# EUROPEAN PATENT SPECIFICATION

(11) **EP 3 046 278 B1**
(45) Date of publication and mention of the grant of the patent: **11.08.2021**
(21) Application number: 15151637.4
(22) Date of filing: 19.01.2015
(51) Int. Cl.: H04H 60/51, H04W 4/021, H04W 4/40, H04H 60/65

(54) **Method for setting different tuner and HMI settings, depending on the location of the tuner**
Verfahren zum Einstellen unterschiedlicher Tuner-und HMI-Einstellungen, abhängig von der Position des Tuners
Procédé de réglage de différents réglages de HMI et de syntoniseur, en fonction de la position du syntoniseur

(43) Date of publication of application: 20.07.2016
(73) Proprietor: Harman Becker Automotive Systems GmbH, 76307 Karlsbad (DE)
(72) Inventor: Schmauderer, Philipp, 75339 Höfen (DE); Benz, Christoph, 77797 Ohlsbach (DE); Gammert, Dominik, 75245 Neulingen (DE); Bötcher, Matthias, 75245 Neulingen (DE)
(74) Representative: Rummler, Felix

(56) References cited:
- DE-A1-102008 025 581
- US-A1- 2009 143 035
- US-A1- 2010 197 255

## Description

### Field of Invention

The present invention relates to method for setting different tuner and HMI settings for a radio receiver, such as a receiver of a car radio in a vehicle or a portable receiver.

### Background of the invention

Nowadays vehicles, in particular, basically all automobiles are usually equipped with car radios. While these units may combine many more functions such as infotainment systems, telematic systems, vehicle-to-vehicle and in vehicle-to-infrastructure systems, support and emergency system, integrated hands-free cell phones, wireless safety communications, automatic driving assistance systems, mobile data, etc. the FM radio function still plays a significant and important role in such systems. FM broadcasting is a VHF broadcasting technology which uses frequency modulation, FM, to provide high-fidelity sound over broadcast radio. According to the International Telecommunication Union, ITU, the term VHF designates the range of radio frequency electromagnetic waves from 30 MHz to 300 MHz. In the following, the description will mostly refer to FM car radio and/or portable FM radios, knowing that such a radio may be combined with a plurality of the other elements mentioned above. In the following, any mentioning of a car radio and/or portable FM radio should in particular include a FM car radio and FM portable radio. In the following, the terms (radio) tuner and (radio) receiver are used synonymously, as only the radio tuning aspect is concerned, not the amplification or audio / sound aspect.

Basically all modern FM radios, in particular car radios, to at least some extent use the Radio Data System, RDS. RDS represents a communications protocol standard for embedding small amounts of digital information in conventional FM radio broadcasts. RDS usually is intended for application for VHF/FM sound broadcasts in the frequency range of 87,5 MHz to 108,0 MHz, which may carry either stereophonic, pilot-tone system, or monophonic programs. RDS typically aims at providing improved functionality for FM tuners / receivers such as program identification, program service name display, and possibly automatic tuning for portable and car radios. Radio Broadcast Data System, RBDS, is the official name used for the U.S. version (North America version) of RDS, whereas the two standards are only slightly different. In the following, the abbreviation RDS should encompass also RBDS, if not explicitly noted otherwise.

RDS as well as RBDS carry data at 1,187.5 bits per second on a 57-kHz subcarrier, such that there are exactly 48 cycles of subcarrier during every data bit. The RBDS/RDS subcarrier is set to the third harmonic of the 19-kHz FM stereo pilot tone to minimize interference and intermodulation between the data signal, the stereo pilot and the 38-kHz DSB-SC stereo difference signal. The stereo difference signal extends up to 38 kHz + 15 kHz = 53 kHz, leaving 4 kHz for the lower sideband of the RDS signal. Double-sideband suppressed-carrier transmission, DSB-SC, is a transmission in which frequencies produced by amplitude modulation are symmetrically spaced above and below the carrier frequency and the carrier level is reduced to the lowest practical level, ideally being completely suppressed.

The RDS data are sent with error correction. RDS defines many features including how private, i.e. in-house, or other undefined features which may be "packaged" in unused program groups. RDS standardizes several types of information transmitted, including time, station identification and program information.

The following is a non-exhaustive list of information fields which are normally contained in the RDS data:

### AF (alternative frequencies)

This allows a receiver to re-tune to a different frequency providing the same station when the first signal becomes too weak, e.g. when moving out of range. This is often utilized in car stereo systems.

### CT (clock time)

This may be used for synchronizing a clock in the receiver or the main clock in a car. Due to transmission uncertainties, CT may only be accurate to within 100 ms of UTC. Also, not all programs may transmit CT information.

### EON (enhanced other networks)

This information allows the receiver to monitor other networks or stations for traffic programs, and automatically temporarily tune into that station.

### PI (program identification)

This is the unique code that identifies the station. Every station receives a specific code with a country prefix. Where the RBDS is applied, the PI code is determined by applying a formula to the station's call sign. The PI code consists of 16 bits and is usually referred to by four hexadecimal characters, or nibbles. The PI code uniquely identifies a program service, within a particular geographical area, where broadcasts sharing the same PI code are guaranteed to be carrying identical program audio. Although there are many designs possible for an RDS receiver, evaluation of the PI code is fundamental to operation. In any receiver with preset memories, it is essential for the PI code of the broadcast to be stored in nonvolatile memory when a service is assigned to a memory location. If no signal with the correct PI code is available, on the last tuned frequency or AFs, when a preset is chosen, the receiver should scan the FM band, stop on each receivable RDS service and evaluate the PI code. The PI code is a hexadecimal code which as such usually is not displayed by the tuner / receiver.

### PS (program service)

This refers to an eight-character static display that represents the call letters or station identity name. Most RDS capable receivers display this information and, if the station is stored in the receiver's presets, will cache this information with the frequency and other details associated with that preset.

### PTY (program type)

This coding of up to 31 pre-defined program types (e.g., in Europe: PTY1 News, PTY6 Drama, PTY11 Rock music) allows users to find similar programming by genre. PTY31 appears to be reserved for emergency announcements in the event of natural disasters or other major calamities.

### REG (regional)

This information is mainly used in countries where national broadcasters run "region-specific" programming such as regional opt-outs on some of their transmitters. This functionality allows the user to "lock-down" the set to their current region or let the radio tune into other region-specific programming as they move into the other region.

### RT (radio text)

This function allows a radio station to transmit a 64-character free-form text that can be either static, such as station slogans, or in sync with the programming, such as the title and artist of the currently playing broadcast or song.

### TA, TP (traffic announcement, traffic program)

The receiver can often be set to pay special attention to this flag and, for example, stop the tape/pause the CD or retune to receive a traffic bulletin. The TP flag is used to allow the user to find only those stations that regularly broadcast traffic bulletins whereas the TA flag is used to signal an actual traffic bulletin in progress, with radio units perhaps performing other actions such as stopping a cassette tape (so the radio can be heard) or raising the volume during the traffic bulletin.

### TMC (traffic message channel)

TMC refers to digitally encoded traffic information. Not all RDS equipment supports this information, but it is often available for automotive navigation systems. In many countries only encrypted traffic data is broadcast, and so an appropriate decoder, possibly tied to a subscription service, is required to use the traffic data.

As far as implementation is concerned, most car radios support at least AF, EON, REG, PS and TA/TP. More expensive car stereos will also offer TMC, RT and / or PTY. Home systems, especially hi-fi receivers, will mainly support functions like PS, RT and PTY.

Ideally, the user of an FM radio with RDS once chooses a program with RDS service and will then not need to re-tune his / her equipment. The AF function of the RDS is usually activated by default. The receiver will have a list of alternative frequencies of various broadcast transmitters broadcasting the same program in the current or adjacent reception areas, and enable receivers equipped with a memory to store the list, to reduce the time for switching to another transmitter. This facility is particularly useful in the case of car and portable radios. Additionally or alternatively, the user will be offered a list of different programs the receiver detects. These are programs which carry RDS information. Via a human machine interface, HMI, the user / driver may select the program he / she would like to follow. Again, the receiver will then use the AF function to follow the broadcast while the driver with her / his vehicle is moving from one reception area into another.

In practice, however, problems for modern FM receivers may arise with regard to the tuner settings of said receivers. Problems may in particular arise in that the broadcast transmitters broadcasting the radio programs not necessarily fully comply with the FM specifications. The FM specifications, in principle, are given in the RECOMMENDATION ITU-R BS.450-3FM. In practice, however, each country of a continent, e.g. Europe, may have different parameters for their broadcast transmitters. These parameters, country by country, may often differ from the above mentioned recommendations. Whereas originally the FM broadcasting grid, i.e. the channel spacing, amounted to 300 kHz - 400 kHz, this has been given up in many countries. Most countries today use a channel spacing of 100 kHz. Few countries use a channel spacing of 200 kHz, however some other countries use a channel spacing of only 50 kHz. In particular, the use of a 50 kHz grid (in general a finer grid), instead of a 100 kHz grid (a coarser standard grid) may give rise to problems, when, e.g. a vehicle passes from one region to another or one country to another and facing a change of the grid, given that the receiver is set up such that it adapts to a 100 kHz grid. This then may result in, for example, problems to tune into programs being 50 kHz off from the 100 kHz grid. A user / driver in his / her car may then encounter the problem not being able to receive programs he might be able to receive, albeit often distorted, using an old transistor radio equipment in the respective country.

Another example may be that in some countries broadcast transmitters use a frequency deviation, i.e. modulation around the base carrier frequency, which exceeds the maximum frequency deviation specified in the recommendations. The maximum frequency deviation is specified as ± 75 kHz or ± 50 kHz, wherein in West European countries and the United States of America, the maximum deviation is ± 75 kHz, whereas in countries of the former USSR and in some other European countries, the maximum deviation is ± 50 kHz. One motivation for using a high frequency deviation may be to make programs louder. For the user of a car radio receiver, a higher frequency deviation may result in disturbing, i.e. leaking power into neighboring channels but may also result in sound problems. This may be particularly a problem in regions where countries border each other and the radio receivers may face many channels with different maximum deviations.

Still other problems may be for reception in an area with many regional programs, even if respecting recommended maximum frequency deviations. Many adjacent channels may occur and influence reception in a negative way. This may result in crosstalk from two different radio transmitters using - at least almost - the same frequency. In many populated areas, there just is not much room or not much room left in the radio spectrum. Stations may be very closely located to each other, sometimes to the point that one may hear several stations on the same frequency, at once.

In view of the above, so far it appears very difficult if not impossible to consider every broadcast characteristics of every country, say for example in Europe. Instead, tuner settings of car radios typically are only adapted to global continent preferences. Thus every single country in Europe, e.g. Italy, France, Germany, UK, Spain, Poland etc. would only get the same global continent tuner settings, despite having quite different broadcast characteristics, some of which may give rise to the problems discussed above.

US patent application US 2010/0197255 A1 discloses a method for analyzing received RDS/RBDS radio signals to determine the country in which a vehicle is situated. Depending on the determined country, an appropriate set of scanned frequencies is assigned to preset push buttons of the vehicle's radio head unit.

US patent application US 2009/0143035 A1 teaches scanning a broadcast band while measuring the parameters of field strength, multipath, and ultrasonic noise at each scanned frequency to determine a current tuner region with a confidence level. A set of operational frequencies used by a radio tuner is automatically changed in accordance with the tuner region into which the radio has moved.

In view of the above-mentioned problems it is an object of the present invention to provide a method for increasing the performance of the FM reception of radio tuners, in particular portable tuners or car radio tuners.

### Summary of the Invention

The above-mentioned is addressed by a method for setting different tuner and human machine interface, HMI, settings of a radio tuner with RDS functionality according to claim 1, as well as a corresponding radio tuner according to claim 6.

The invention provides a method for setting different tuner and human machine interface, HMI, settings of a radio tuner with RDS functionality comprising the steps of:
evaluating the at least one RDS signal of a broadcast received by the radio tuner;
determining current country and/or current region in accordance with the at least one RDS signal;
adjusting tuner settings of the radio tuner in accordance with the determined current country and/or current region; and
updating the HMI settings of the radio tuner in accordance with the current country and/or current region.

Typically, the radio tuner is provided with a pre-stored default setting reflecting standard, global continent settings. Every single country and/ or region gets the same global tuner settings for different broadcast transmitter characteristics. Country or regional tuner settings are known but are not respected in the default setting. However, the reception of the radio tuner may likely improve, if the tuner adjusts its parameters, i.e. its default settings to those known transmitter properties. A similar situation arises when the radio tuner or a device comprising the radio tuner relocates between countries or regions, respectively, e.g. a user using the portable device or a driver with the car moves to yet another country or back to a country of origin. There, again, a readjustment of tuner settings may likely improve the radio reception. The updating of the HMI settings of the radio tuner, e.g. presenting the user with a list of selectable programs, all of which carry a RDS signal, is closely connected with the adjusting or re-adjusting of the tuner settings. Thus the user may be provided with the most up to date list of programs or stations which may be receivable in the current region of the current country in which he/she uses the radio tuner. A dynamic loading of different tuner parameters, depending on the broadcast country and/or region, may cause a better FM reception, and/or may show different HMI settings, which in particular may depend on the grid.

The method further comprises the step of providing a database of different predetermined tuner parameters stored in a storage unit comprised in the radio tuner.

Typically, experienced radio developers know which country uses which broadcast transmitting preferences. This information may become very detailed. Therefore, this information may be stored in a database. The database may be stored in a storage unit of the radio tuner. It may also be possible that the storage unit and the radio tuner together form a system or are part of an infotainment system or a portable system. The database may be pre-programmed.

The method further comprises the step of loading specific tuner parameters from the database based on the evaluating step.

In the method, adjusting tuner settings of the radio tuner comprises adjusting tuner settings in accordance with the loaded specific tuner parameters.

The evaluating step provides the result of the current country and current region. According to the result of the evaluation the respective specific tuner parameters are searched in and loaded from the database. Then, the adjusting utilizes these specific tuner parameters for adjusting the tuner parameters which are used up until the adjusting step in order to improve the FM reception.

In the method, determining the current country and/ or current region may further comprise decoding the PI code and/or the Extended Country Code, ECC and determining the current country and/ or current region from the decoded PI code and/or ECC.

The first most significant bits of the PI code carries the RDS country code. The four bit coding structure allows the definition of 15 different codes, 0x1 to 0xF. Thus, fifteen countries could be identified without sharing a common PI code. The ECC together with the PI code may render a unique combination. The ECC consists of eight bits. Full listings of the ECC and PI country / area codes are given for European countries in CENELEC EN 50067:1998, Annex D, and for the rest of the world in Annex N of the same document. One example may be that Spain, Sweden, and Romania all share the same PI code, namely E (E being a hexadecimal number). However, these countries may be distinguished by further using the ECC, e.g. Romania: E1, Spain: E2, and Sweden: E3. Therefore these countries may be uniquely identified by the PI code together with the ECC.

The method may further comprise that the PI code and/or the ECC are decoded from RDS group 1A. The PI code is transmitted in every group - however the ECC is transmitted by variant 0 of block 3 of type 1A group.

Information about the country which broadcasts the selected station may be found in the PI code and in the extended country code of RDS group 1A. This may allow that individual broadcast transmitter characteristics are considered by the receiver.

In the method, adjusting tuner settings of the radio tuner may comprise adjusting concealment settings for the current country and/or current region.

The concealment settings refer to the strategies of concealment of reception errors when a reception of a broadcast becomes weak, such as switching from stereo to mono, using of filters etc. The concealment settings may be influenced by the quality of the signal received. A first concealment strategy may be to adjust or re-adjust tuner settings according to the current country and/or current region. This may include updating the current country and/or current region information evaluated from the RDS signal.

The method may further comprise updating the database with an amended set of different predetermined tuner parameters.

The database stored in the storage unit may be updatable. This may be done during a service update. Also, this may be done via an update signaled by the radio tuner or a system into which the radio tuner is integrated. It is understood that the user may trigger an update of the database. The database may also be updated by means of remote data transmission.

The invention also provides a radio tuner with RDS functionality, comprising:
an evaluation unit configured to evaluate at least one RDS signal of a broadcast received by the radio tuner;
a determining unit configured to determine current country and/or current region in accordance with the at least one RDS signal;
an adjusting unit configured to adjust tuner settings of the radio tuner in accordance with the determined current country and/or current region; and
an updating unit configured to update HMI settings of the radio tuner of the radio tuner in accordance with the determined current country and/or current region.

The advantages of the radio tuner with RDS functionality are the same as discussed for the corresponding method, above.

The radio tuner further comprises a storage unit configured to store a database of different predetermined tuner parameters;

In the radio tuner, the adjusting unit is further configured to load specific tuner parameters from the database based on the evaluating step, and is configured to adjust tuner settings in accordance with the loaded specific tuner parameters.

In the radio unit, the determining unit may be further configured to decode the PI code and/or the Extended Country Code, ECC, and may be configured to determine the current country and/ or current region from the decoded PI code and/or ECC.

In the radio tuner, the determining unit may be configured to decode the PI code and/or the ECC from RDS group 1A.

The invention further provides an infotainment system installed in a vehicle, comprising a radio tuner as described above.

The invention further provides a portable device comprising a radio tuner as described above.

The radio tuner may be installed in a vehicle, either as a car radio or as a part of an infotainment system of the vehicle. Likewise, the radio tuner may be included into a portable device such as a mobile phone, smartphone or even a tablet computer.

Additional features and advantages of the present invention will be described with reference to the drawings. In the description, reference is made to the accompanying figures that are meant to illustrate preferred embodiments of the invention. It is understood that such embodiments do not represent the full scope of the invention.

### Brief Description of the Drawings

Figures 1A and 1B illustrate a vehicle using an RDS radio tuner crossing a country or a regional border, according to an example of the present invention.
Figure 2 shows a flow chart of the herein disclosed inventive method for setting different tuner and human machine interface, HMI, settings of a radio tuner with RDS functionality.
Figure 3 shows a further flow chart of the method of Figure 2, however showing additional step of a further embodiment of the herein disclosed inventive method for A method for setting different tuner and human machine interface, HMI, settings of a radio tuner with RDS functionality.
Figure 4 shows a radio tuner with RDS functionality corresponding to the method as shown in Figures 2 and 3 according to the present invention.
Figure 5A shows a portable device such as a smartphone including a radio tuner according to Figure 4.
Figure 5B shows a front part of a car, i.e. windscreen, steering wheel and a dashboard including an infotainment system including a radio tuner according to Figure 4.

### Detailed Description

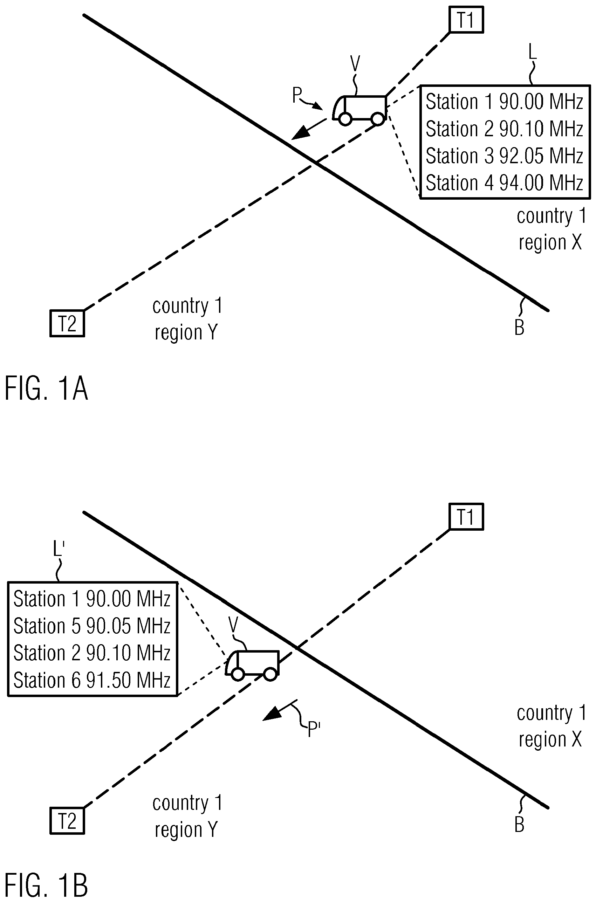

Figures 1A and 1B illustrate a vehicle using an RDS radio tuner crossing a country or a regional border, according to an example of the present invention. Figures 1A and 1B both show a vehicle V.

In Figure 1A the vehicle V moves towards a regional border or a country border B in the direction of arrow P.

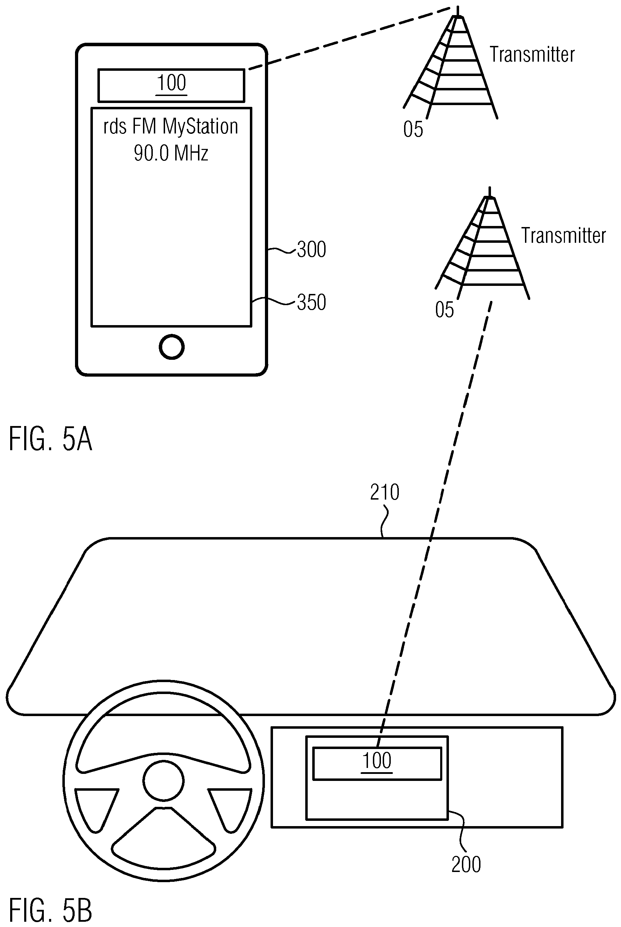

In Figure 1B the vehicle is moving away from the border B in the direction of arrow P'. The vehicle V includes an RDS radio tuner. This may be radio tuner as included in an infotainment system, see Figure 5B. In a zoomed in portion of Figures 1A part L of a display of the radio tuner of vehicle V is shown. In Figure 1A part L displays four different stations which the driver of vehicle V may choose. Likewise, in Figure 1B, part L' displays four different stations. It should be understood that for the sake of legibility the number of stations displayed is four, but a different number of stations may be displayed. For the sake of example, these stations are denoted Station 1, Station 2, Station 3, and Station 3. The channel spacing of these stations in Figure 1A is at least 100 kHz or more.

Figure 1A further shows broadcast transmitter T1 located in country / region X broadcasting at least the programs Station 1, Station 2, Station 3, and Station 4. Figure 1B shows transmitter T2 broadcasting at least the programs Station 1, Station 5, Station 2, and Station 6. It should be noted that in country / region Y the channel spacing between program Station 1 and program Station 2 is only 50 kHz, a value not present for the programs transmitted by transmitter T1 according to the transmitting preferences of country / region X. The adjusting of the RDS tuner settings resulting in the updated display of part L' is explained in the following Figures.

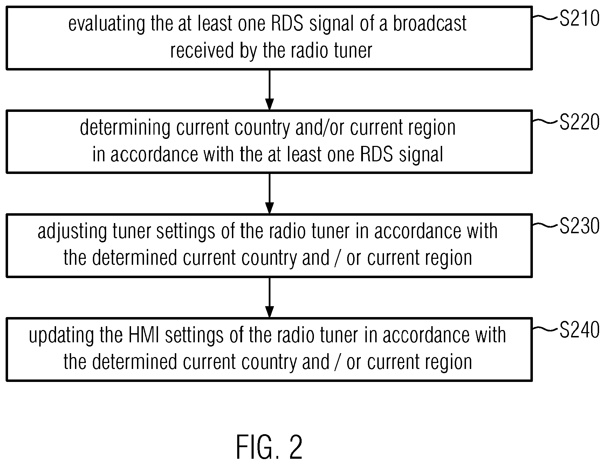

In Figure 2 a flow chart illustrates the herein disclosed inventive method for setting different tuner and human machine interface, HMI, settings of a radio tuner with RDS functionality.

In the flow chart as shown in Figure 2, in step S210 the at least one RDS signal of a broadcast received by the radio tuner is evaluated. The RDS signal may be carried by at least one of the programs as exemplarily shown in Figure 1. In step S220 the method proceeds with determining current country and/or current region in accordance with the at least one RDS signal received by the radio tuner. With regard to the exemplary scenario shown in Figure 1, this will yield different results before and after crossing the country or regional border B in Figure 1. This will also change again once the vehicle returns from country / region Y back to country / region X. Therefore, the radio tuner has available the broadcast transmitter settings of a country and/or region in which the radio tuner, for example in a vehicle, is currently positioned. In step S230 the method proceeds by adjusting the tuner settings of the radio tuner in accordance with the determined current country and/or current region. The current country and/or current region will be a token for the available broadcast transmitter settings to be used for the adjusting. Therefore, the tuner settings of the radio tuner may be properly adapted and adjusted. The method proceeds with step S240 by updating the HMI settings of the radio tuner in accordance with the current country and/or current region. Thus a list of station related information for the user of the radio tuner may be adapted to the present broadcast transmitter settings. In particular, the user may be able to choose stations / channels in accordance with the present broadcast transmitter settings which he could not have been offered with the previous or with standard settings.

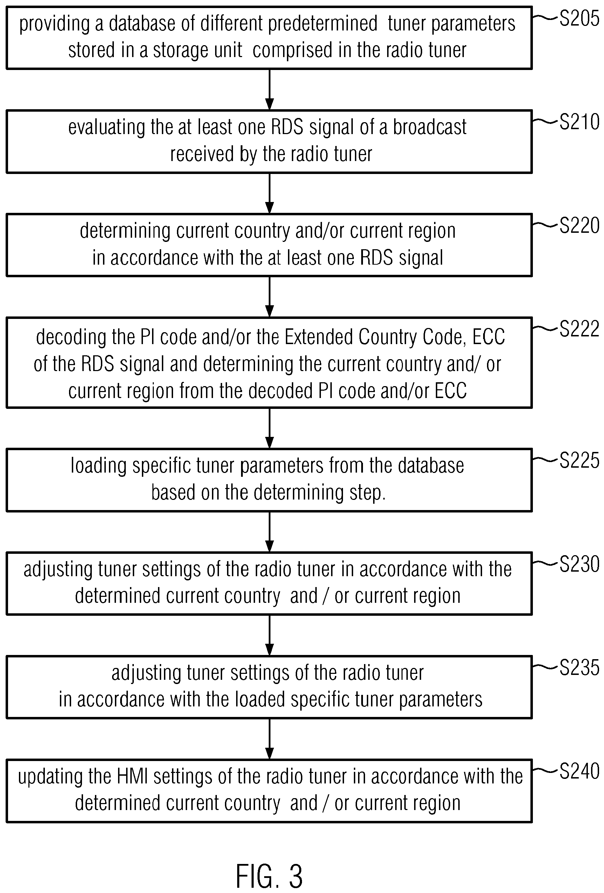

In Figure 3 a flow chart illustrates the herein disclosed inventive method for setting different tuner and human machine interface, HMI, settings of a radio tuner with RDS functionality. The flow chart of Figure 3 corresponds to the flow chart of Figure 2 but shows further steps and details. Steps of Figure 3 which correspond to the steps of Figure 2 are denoted with the same reference numbers and will not be explained, again. In step S205 it is shown that it is provided a database of different predetermined tuner parameters. These different predetermined tuner parameters are stored in a storage unit. The storage unit typically may be comprised in the radio tuner. With regard to the database of different predetermined tuner parameters, this may comprise all or at least all relevant broadcast transmitter preferences of countries in which the RDS radio tuner is to be used. In step S222 the current country and/ or current region are determined by decoding the PI code and/or the Extended Country Code, ECC from the evaluated RDS signal and the determining the current country and/ or current region from the decoded PI code and/or ECC. The radio tuner may interact with the database in that in step S225 specific tuner parameters are loaded from the database based on the evaluating step. In step S235 the tuner settings are adjusted in accordance with the loaded specific tuner parameters corresponding to the current country and/or current region as decoded and determined from the PI code and the ECC. The flow chart then concludes with step S240 as described with respect to Figure 2.

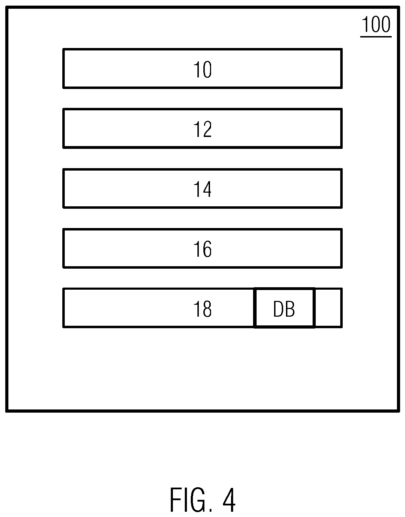

Figure 4 schematically shows a radio tuner 100 with RDS functionality corresponding to the method as shown in Figures 2 and 3, according to the present invention. In particular, Figure 4 shows that the radio tuner 100 comprises an evaluation unit 10. The evaluation unit 10 may be configured to evaluate at least one RDS signal of a broadcast received by the radio tuner 100. This RDS signal may be transmitted by a broadcast transmitter as depicted in Figure 1 or in Figures 5A and 5B. The radio tuner 100 may further comprise a determining unit 12. The determining unit 12 may be configured to determine current country and/or current region in accordance with the at least one RDS signal. The radio tuner 100 further may comprise an adjusting unit 14. The adjusting unit may be configured to adjust tuner settings of the radio tuner 100 in accordance with the determined current country and/or current region. The radio tuner 100 may also comprise an updating unit 16 configured to update HMI settings of the radio tuner 100 in accordance with the determined current country and/or current region. Moreover, the radio tuner 100 may further comprise a storage unit 18. The storage unit 18 may be configured to store a database DB of different predetermined tuner parameters. The database DB is shown in Figure 4 as being included, i.e. stored in the storage unit 18. It is understood that the determining unit 12, the adjusting unit 14, the updating unit 16, and the storage unit 18 may interact with each other, respectively. One or more of the determining unit 12, the adjusting unit 14, the updating unit 16 may be either implemented as a physical or a logical unit of a processor. In particular, the adjusting unit 14 may be configured to load specific tuner parameters from the database DB based on the evaluating step. Subsequently, the adjusting unit 14 may be configured to adjust tuner settings in accordance with the loaded specific tuner parameters. The determining unit 12 may be configured to decode the PI code and/or the Extended Country Code, ECC and is configured to determine the current country and/ or current region from the decoded PI code and/or ECC. In particular the determining unit 12 may be configured to decode the PI code and/or the ECC from RDS group 1A. Based on the result of the decoding, the adjusting of the tuner settings may be performed by the adjusting unit.

Figure 5A shows a portable device such as a smartphone 300 including a radio tuner 100 according to Figure 4. It should be understood that a smartphone is only one example for other portable device, such as handheld computers, tablets or the like, which are provided with an RDS radio tuner. In Figure 4, the radio tuner 100 comprised in the smartphone 300 receives broadcast transmitted from transmitter 05. On the display 350 of the smartphone, either a list of available stations and/or a station presently tuned to is displayed. The list of available stations may change as shown in the example of Figure 1.

Likewise, Figure 5B shows a front part 210 of a car, i.e. windscreen, steering wheel and a dashboard including an infotainment system 200 including a radio tuner 100 according to Figure 4. Similar as explained with regard to Figure 1 and Figure 5A, the infotainment system 200 may display either a list of available stations and/or a station presently tuned to is displayed. The list of available stations may vary as shown in the example of Figure 1. In accordance with the present invention, the user may be offered improved FM reception by adjusting to the broadcast transmitter settings as discussed with regard to Figures 1 - 4.

All previously discussed embodiments are not intended as limitations but serve as examples illustrating features and advantages of the invention. It is to be understood that some or all of the above described features can also be combined in different ways.

## Claims

1. A method for setting different tuner and human machine interface, HMI, settings of a radio tuner (100) with RDS functionality, comprising the steps of:
providing (S205) a database of different predetermined tuner parameters with regard to country- and region-specific broadcast transmitting preferences stored in a storage unit comprised in the radio tuner (100);
receiving, by the radio tuner (100), at least one RDS signal of a broadcast comprising a PI code and an Extended Country Code, ECC, and evaluating (S210) the received at least one RDS signal;
determining (S220) a current country and a current region by decoding (S222) the PI code and the ECC and determining (S222) the current country and current region from the decoded PI code and ECC;
loading (S225) specific tuner parameters from the database based on the determined current country and current region;
adjusting (S230) tuner settings of the radio tuner (100) with respect to country- and region-specific broadcast characteristics in accordance with the determined current country and current region; and
updating (S240) the HMI settings of the radio tuner (100) in accordance with the current country and current region;
wherein the country- and region-specific broadcast characteristics include channel spacings and/or a maximum frequency deviation; and
wherein adjusting tuner settings of the radio tuner (100) comprises adjusting (S235) tuner settings in accordance with the loaded specific tuner parameters.

2. The method according to claim 1, wherein the PI code and the ECC are decoded from RDS group 1A.

3. The method according to claim 1 or 2, wherein adjusting tuner settings of the radio tuner (100) further comprises adjusting concealment settings for the current country and current region.

4. The method according to at least one of claims 1 - 3, further comprising updating the database with an amended set of different predetermined tuner parameters.

5. A radio tuner (100) with RDS functionality, comprising:
a storage unit (18) configured to store a database of different predetermined tuner parameters with regard to country- and region-specific broadcast transmitting preferences;
an evaluation unit (10) configured to evaluate at least one RDS signal of a broadcast received by the radio tuner (100);
a determining unit (12) configured to determine a current country and a current region in accordance with the at least one RDS signal, wherein the determining unit (12) is further configured to decode the PI code and the Extended Country Code, ECC and is configured to determine the current country and current region from the decoded PI code and ECC;
an adjusting unit (14) configured to load specific tuner parameters from the database based on the determined current country and current region and to adjust tuner settings of the radio tuner (100) with respect to country- and region-specific broadcast characteristics in accordance with the loaded specific tuner parameters; and
an updating unit (16) configured to update HMI settings of the radio tuner (100) in accordance with the determined current country and current region;
wherein the country- and region-specific broadcast characteristics include channel spacings and/or a maximum frequency deviation.

6. The radio tuner (100) according to claim 5, wherein the determining unit is configured to decode the PI code and the ECC from RDS group 1A.

7. Infotainment system (300) installed in a vehicle, comprising a radio tuner (100) according to claim 5 or 6.

8. Portable device (200) comprising a radio tuner (100) according to at least one of claims 5-7.

## Patentansprüche

1. Verfahren zum Einstellen unterschiedlicher Tuner- und Mensch-Maschine-Schnittstellen(HMI)-Einstellungen eines Radiotuners (100) mit RDS-Funktionalität, umfassend die folgenden Schritte:
Bereitstellen (S205) einer Datenbank unterschiedlicher vorbestimmter Tunerparameter hinsichtlich länder- und regionsspezifischer Rundfunkübertragungspräferenzen, die in einer Speichereinheit gespeichert sind, die in dem Radiotuner (100) umfasst ist;
Empfangen mindestens eines RDS-Signals eines Rundfunks durch den Radiotuner (100), umfassend einen PI-Code und eine erweiterte Länderkennung (ECC), und Beurteilen (S210) des empfangenen mindestens einen RDS-Signals;
Bestimmen (S220) eines aktuellen Landes und einer aktuellen Region durch Decodieren (S222) des PI-Codes und der ECC und Bestimmen (S222) des aktuellen Landes und der aktuellen Region aus dem decodierten PI-Code und ECC;
Laden (S225) spezifischer Tunerparameter von der Datenbank basierend auf dem bestimmten aktuellen Land und der bestimmten aktuellen Region;
Anpassen (S230) von Tunereinstellungen des Radiotuners (100) in Bezug auf länder- und regionsspezifische Rundfunkeigenschaften gemäß dem bestimmten aktuellen Land und der bestimmten aktuellen Region; und
Aktualisieren (S240) der HMI-Einstellungen des Radiotuners (100) gemäß dem aktuellen Land und der aktuellen Region;
wobei die länder- und regionsspezifischen Rundfunkeigenschaften Kanalabstände und/oder eine maximale Frequenzabweichung beinhalten; und
wobei das Anpassen von Tunereinstellungen des Radiotuners (100) Anpassen (S235) von Tunereinstellungen gemäß den geladenen spezifischen Tunerparametern umfasst.

2. Verfahren nach Anspruch 1, wobei der PI-Code und die ECC aus RDS-Gruppe 1A decodiert sind.

3. Verfahren nach Anspruch 1 oder 2, wobei das Anpassen von Tunereinstellungen des Radiotuners (100) ferner Anpassen von Geheimhaltungseinstellungen für das aktuelle Land und die aktuelle Region umfasst.

4. Verfahren nach mindestens einem der Ansprüche 1-3, ferner umfassend Aktualisieren der Datenbank mit einem abgeänderten Satz von unterschiedlichen vorbestimmten Tunerparametern.

5. Radiotuner (100) mit RDS-Funktionalität, umfassend:
eine Speichereinheit (18), die zum Speichern einer Datenbank von unterschiedlichen vorbestimmten Tunerparametern hinsichtlich länder- und regionsspezifischer Rundfunkübertragungspräferenzen konfiguriert ist;
eine Beurteilungseinheit (10), die zum Beurteilen mindestens eines RDS-Signals eines Rundfunks, der durch den Radiotuner (100) empfangen wird, konfiguriert ist;
eine Bestimmungseinheit (12), die zum Bestimmen eines aktuellen Landes und einer aktuellen Region gemäß dem mindestens einen RDS-Signal konfiguriert ist, wobei die Bestimmungseinheit (12) ferner zum Decodieren des PI-Codes und der erweiterten Länderkennung (ECC) konfiguriert ist und zum Bestimmen des aktuellen Landes und der aktuellen Region aus dem decodierten PI-Code und der decodierten ECC konfiguriert ist;
eine Anpassungseinheit (14), die zum Laden spezifischer Tunerparameter aus der Datenbank basierend auf dem bestimmten aktuellen Land und der bestimmten aktuellen Region und zum Anpassen von Tunereinstellungen des Radiotuners (100) in Bezug auf länder- und regionsspezifische Rundfunkeigenschaften gemäß den geladenen spezifischen Tunerparametern konfiguriert ist; und
eine Aktualisierungseinheit (16), die zum Aktualisieren von HMI-Einstellungen des Radiotuners (100) gemäß dem bestimmten aktuellen Land und der bestimmten aktuellen Region konfiguriert ist;
wobei die länder- und regionsspezifischen Rundfunkeigenschaften Kanalabstände und/oder eine maximale Frequenzabweichung beinhalten.

6. Radiotuner (100) nach Anspruch 5, wobei die Bestimmungseinheit zum Decodieren des PI-Codes und der ECC aus RDS-Gruppe 1A konfiguriert ist.

7. Infotainment-System (300), das in einem Fahrzeug installiert ist, umfassend einen Radiotuner (100) nach Anspruch 5 oder 6.

8. Tragbare Vorrichtung (200), umfassend einen Radiotuner (100) nach mindestens einem der Ansprüche 5-7.

## Revendications

1. Procédé de réglage de différents réglages de syntoniseur et d'interface homme-machine, HMI, d'un syntoniseur radio (100) avec fonctionnalité RDS, comprenant les étapes suivantes :
la fourniture (S205) d'une base de données de différents paramètres de syntoniseur prédéterminés concernant des préférences de transmission de radiodiffusion spécifiques au pays et à la région, stockées dans une unité de stockage comprise dans le syntoniseur radio (100) ;
la réception, par le syntoniseur radio (100), d'au moins un signal RDS d'une radiodiffusion comprenant un code PI et un code de pays étendu, ECC, et l'évaluation (S210) de l'au moins un signal RDS ;
la détermination (S220) d'un pays actuel et d'une région actuelle en décodant (S222) le code PI et l'ECC et en déterminant (S222) le pays actuel et la région actuelle à partir du code PI et de l'ECC décodés ;
le chargement (S225) de paramètres de syntoniseur spécifiques à partir de la base de données sur la base du pays actuel et de la région actuelle déterminés ;
l'ajustement (S230) de réglages de syntoniseur du syntoniseur radio (100) par rapport à des caractéristiques de radiodiffusion spécifiques au pays et à la région conformément au pays actuel et à la région actuelle déterminés ; et
la mise à jour (S240) des réglages de HMI du syntoniseur radio (100) conformément au pays actuel et à la région actuelle ;
dans lequel les caractéristiques de radiodiffusion spécifiques au pays et à la région incluent des espacements de canaux et/ou une déviation maximale de fréquence ; et
dans lequel l'ajustement de réglages de syntoniseur du syntoniseur radio (100) comprend l'ajustement (S235) de réglages de syntoniseur conformément aux paramètres de syntoniseur spécifiques chargés.

2. Procédé selon la revendication 1, dans lequel le code PI et l'ECC sont décodés à partir du groupe 1A de RDS.

3. Procédé selon la revendication 1 ou 2, dans lequel l'ajustement de réglages de syntoniseur du syntoniseur radio (100) comprend en outre l'ajustement de réglages de dissimulation pour le pays actuel et la région actuelle.

4. Procédé selon au moins une des revendications 1 à 3, comprenant en outre la mise à jour de la base de données avec un ensemble modifié de différents paramètres de syntoniseur prédéterminés.

5. Syntoniseur radio (100) avec fonctionnalité RDS, comprenant :
une unité de stockage (18) configurée pour stocker une base de données de différents paramètres de syntoniseur prédéterminés concernant des préférences de transmission de radiodiffusion spécifiques au pays et à la région ;
une unité d'évaluation (10) configurée pour évaluer au moins un signal RDS d'une radiodiffusion reçue par le syntoniseur radio (100) ;
une unité de détermination (12) configurée pour déterminer un pays actuel et une région actuelle conformément à l'au moins un signal RDS, dans lequel l'unité de détermination (12) est configurée en outre pour décoder le code PI et le code de pays étendu, ECC, et est configurée pour déterminer le pays actuel et la région actuelle à partir du code PI et de l'ECC décodés ;
une unité d'ajustement (14) configurée pour charger des paramètres de syntoniseur spécifiques à partir de la base de données sur la base du pays actuel et de la région actuelle déterminés et pour ajuster des réglages de syntoniseur du syntoniseur radio (100) par rapport à des caractéristiques de radiodiffusion spécifiques au pays et à la région conformément aux paramètres de syntoniseur spécifiques chargés ; et
une unité de mise à jour (16) configurée pour mettre à jour des réglages de HMI du syntoniseur radio (100) conformément au pays actuel et à la région actuelle déterminés ;
dans lequel les caractéristiques de radiodiffusion spécifiques au pays et à la région incluent des espacements de canaux et/ou une déviation maximale de fréquence.

6. Syntoniseur radio (100) selon la revendication 5, dans lequel l'unité de détermination est configurée pour décoder le code PI et l'ECC à partir du groupe 1A de RDS.

7. Système d'info-divertissement (300) installé dans un véhicule, comprenant un syntoniseur radio (100) selon la revendication 5 ou 6.

8. Dispositif portable (200) comprenant un syntoniseur radio (100) selon au moins une des revendications 5 à 7.
